# EUROPÄISCHE PATENTSCHRIFT

(11) **EP 0 540 764 B1**
(45) Veröffentlichungstag und Bekanntmachung des Hinweises auf die Patenterteilung: **07.06.1995**
(21) Anmeldenummer: 91117223.7
(22) Anmeldetag: 09.10.1991
(51) Int. Cl.: H04L 1/24, H04L 27/00

(54) **Demodulatorbaustein zur Systemüberwachung während des Betriebes**
Demodulator unit arranged to check for system failures during operation
Unité de démodulation permettant de contrôler les défaillances du système pendant le fonctionnement

(43) Veröffentlichungstag der Anmeldung: 12.05.1993
(73) Patentinhaber: Bodenseewerk Gerätetechnik GmbH, 88662 Überlingen (DE)
(72) Erfinder: Marschall, Klaus Wolfgang, Dipl.-Ing., W-7758 Meersburg (DE)
(74) Vertreter: Weisse, Jürgen, Dipl.-Phys. Patentanwalt

(56) Entgegenhaltungen:
- EP-A- 0 403 147
- DE-A- 3 234 787
- DE-A- 4 010 798
- US-A- 3 787 810
- US-A- 3 889 109

## Beschreibung

Die Erfindung betrifft einen Demodulatorbaustein mit einer Demodulatorschaltung, einem ersten Eingang und einem mit der Demodulatorschaltung verbundenen Ausgang.

Die Erfindung betrifft weiterhin eine mit einem solchen Demodulatorbaustein aufgebaute Signalverarbeitungsschaltung.

Ein solcher Demodulatorbaustein empfängt serielle, digitale Worte z.B. nach der ARINC 429-Luftfahrtnorm, und dient dazu, ein bidirektionales "return-to-zero" - Signal mit zwei Spannungspegeln von beispielsweise +/- 12,5 Volt, wie es in der ARINC 429-Luftfahrtnorm spezifiziert ist, in zwei gegeneinander invertierte TTL-kompatible "non-return-to-zero" - Ausgangssignale umzusetzen. Diese können dann in einer rein digitalen Empfangslogik weiterverarbeitet werden.

Bausteine dieser Art zur Demodulation von ARINC 429 Signalen sind bekannt.

Bei den Spezifikationen für den Bau von Luftfahrtgeräten wird die Prüfbarkeit der Bausteine im Betrieb (Built In Test) bis auf die Ebene der Bausteine gefordert (ABD 0048 der Airbus Industrie). Eine solche Prüfung ist mit den bekannten Demodulatorbausteinen nicht möglich.

Die DE 32 34 787 A1 beschreibt eine Einrichtung zum Überprüfen des ordnungsgerechten Betriebsverhaltens von Abgabe- und Empfangseinrichtungen. Zum Zweck der Überprüfung wird an die Abgabeeinrichtung ein Signal gegeben, welches die Nutzinformation abschaltet und statt dessen eine andere Information überträgt.

Eine weitere Einrichtung zum Überprüfen des ordnungsgerechten Betriebsverhaltens von Abgabe- und Empfangseinrichtungen ist aus der US-PS 3 889 109 bekannt. Hier werden die Daten von einem Prozessor zur Abgabeeinrichtung, zur Empfangseinrichtung und zurück zum Prozessor gegeben. Wenn Fehler festgestellt werden, können wahlweise die Abgabeeinrichtung bzw. die Empfangseinrichtung überbrückt werden, so dass festgestellt werden kann, wo die Fehler entstehen.

Weitere Prüfeinrichtungen sind aus der De-A-32 34 787, der EP-A-0 403 147 und der US-A-3 787 810 bekannt.

Der Erfindung liegt die Aufgabe zugrunde, einen Demodulatorbaustein der eingangs definierten Art so auszubilden und zu schalten, dass eine Prüfung im Betrieb möglich ist.

Der Erfindung liegt weiter die Aufgabe zugrunde, einen Demodulatorbaustein der eingangs genannten Art so auszubilden und zu schalten, dass er auch eine Prüfung anderer zum System gehöriger Bauteile gestattet.

Erfindungsgemäss wird diese Aufgabe dadurch gelöst, dass
a) der Demodulatorbaustein eine erste und eine zweite Demodulatorschaltung (90, 106) enthält,
b) der Demodulatorbaustein weiterhin einen ersten, der ersten Demodulatorschaltung zugeordneten Multiplexer und einen zweiten, der zweiten Demodulatorschaltung zugeordneten Multiplexer enthält,
c) der erste Eingang des Demodulatorbausteins über den ersten Multiplexer auf die erste Demodulatorschaltung aufschaltbar ist,
d) ein zweiter Eingang über den ersten Multiplexer auf die erste Demodulatorschaltung aufschaltbar ist,
e) der Demodulatorbaustein einen dritten Eingang aufweist,
f) der zweite Eingang über den zweiten Multiplexer wahlweise auf die zweite Demodulatorschaltung aufschaltbar ist,
g) der dritte Eingang über den zweiten Multiplexer wahlweise auf die zweite Demodulatorschaltung aufschaltbar ist,
h) der Demodulatorbaustein einen ersten Ausgang aufweist, der mit der ersten Demodulatorschaltung verbunden ist, und einen zweiten Ausgang aufweist, der mit der zweiten Demodulatorschaltung verbunden ist, und
i) der erste Multiplexer von einem ersten Auswahleingang des Demodulatorbausteins gesteuert ist und der zweite Multiplexer von einem zweiten Auswahleingang des Demodulatorbausteins gesteuert ist.

Bei einem solchen Demodulatorbaustein kann auf den zweiten Eingang wahlweise ein operatives Signal vom einem Modulator des gleichen Systems über eine Prüfrückführschleife aufgeschaltet werden. Ein Prozessor prüft, ob dieses Signal von dem Demodulatorbaustein in das richtige Ausgangssignal bzw. Datenwort umgesetzt wird. Wenn dies nicht der Fall ist, ist entweder der Modulator oder der Demodulatorbaustein defekt.

Das über die Prüfrückführschleife auf den zweiten Eingang aufgeschaltete operative Signal von dem Modulator wird zunächst von dem ersten Multiplexer auf die erste Demodulatorschaltung gegeben. Wenn das Signal am ersten Ausgang nicht mit dem auf den Modulator geschalteten Signal übereinstimmt, erfolgt eine Umschaltung: Das auf den zweiten Eingang aufgeschaltete operative Signal wird von dem zweiten Multiplexer auf die zweite Demodulatorschaltung gegeben. Liefert diese zweite Demodulatorschaltung an dem zweiten Ausgang ein Signal, das mit dem auf den Modulator aufgeschalteten Signal übereinstimmt, ist dies ein Anzeichen dafür, dass die erste Demodulatorschaltung defekt ist. Erscheint an dem zweiten Ausgang ebenfalls kein Signal, das dem auf den Modulator gegebenen Signal entspricht, so ist dies ein Anzeichen für einen Defekt des Modulators.

Vorteilhafterweise sind zu Prüfzwecken Signale im operativen Betrieb auf den zweiten Eingang aufschaltbar und durch den Demodulatorbaustein verarbeitbar.

Die Erfindung sieht ferner eine Signalverarbeitungsanordnung vor mit einem Prozessor, der über einen Datenbus und einen Sender/Empfänger-Bauteil Signale auf einen Modulator zur Weitergabe an den Systembus eines ersten Gerätes liefert und vom Systembus eines zweiten Gerätes Signale über einen Demodulatorbaustein der vorstehend beschriebenen Art, den Sender/Empfänger-Bauteil und den Datenbus erhält, wobei der Ausgang des Modulators über eine Prüfrückführschleife mit dem zweiten Eingang des Demodulatorbauteils verbunden ist.

Ein Ausführungsbeispiel der Erfindung ist nachstehend unter Bezugnahme auf die zugehörigen Zeichnungen näher erläutert.
- Fig.1: zeigt ein Blockdiagramm eines Demodulatorbauteils, das eine Prüfung im Betrieb zuläßt.
- Fig.2: zeigt ein Blockdiagramm einer Signalverarbeitungsanordnung mit einem Demodulatorbaustein, wobei der Demodulatorbaustein einer Prüfung im Betrieb unterworfen werden kann.

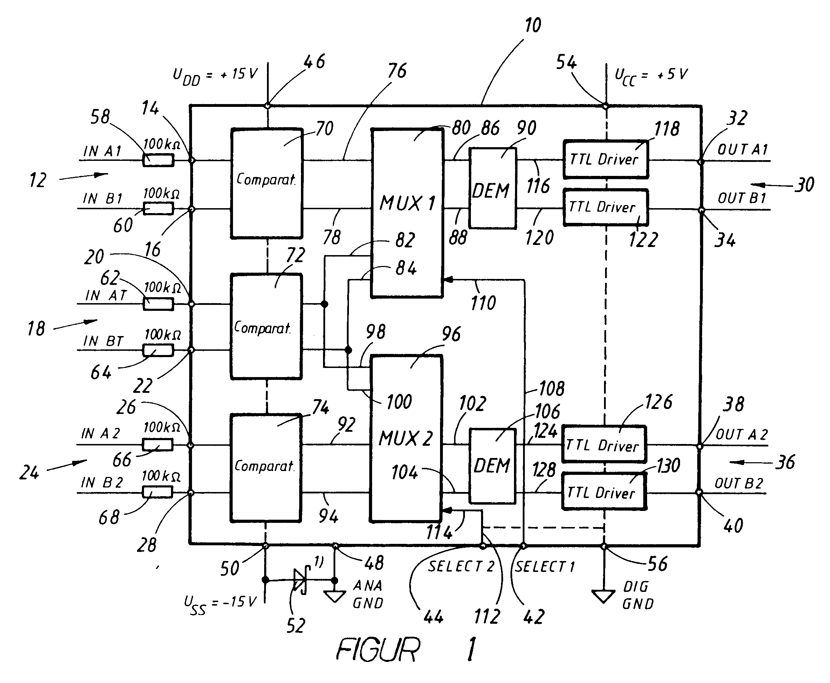

In Fig. 1 ist mit 10 ein Demodulatorbaustein bezeichnet. Der Demodulatorbaustein 10 weist einen ersten Eingang 12 mit Anschlüssen 14 und 16 auf. Der Demodulatorbaustein 10 hat weiterhin einen zweiten Eingang 18 mit Anschlüssen 20 und 22. Schließlich hat der Demodulatorbaustein 10 einen dritten Eingang 24 mit Anschlüssen 26 und 28. Der Demodulatorbaustein 10 hat einen ersten Ausgang 30 mit einem ersten Anschluss 32 und einem zweiten Anschluss 34. Das an dem zweiten Anschluss 34 erscheinende Signal ist invers zu dem an dem ersten Anschluss 32 erscheinenden Signal. Der Demodulatorbaustein 10 hat einen zweiten Ausgang 36 mit einem ersten Anschluss 38 und einem zweiten Anschluss 40. Das an dem zweiten Anschluss 40 anliegende Signal ist invers zu dem an dem ersten Anschluss 38 anliegenden Signal. Weiterhin weist der Demodulatorbaustein 10 einen ersten Ansteuereingang 42 mit einem Anschluss und einen zweiten Ansteuereingang 44 mit einem Anschluss auf. An einem Anschluss 46 liegt eine Versorgungsspannung von + 15 Volt. Ein Anschluss 48 ist mit der "analogen" Masse verbunden. An einem Anschluss 50 liegt eine Versorgungsspannung von - 15 Volt. Der Spannungseingang von - 15 Volt ist gegen Masse durch eine Schottkydiode 52 gegen Spannungsausfall geschützt. An einem Anschluss 54 liegt eine Spannung von + 5 Volt. Ein Anschluss 56 ist mit der "digitalen" Masse verbunden.

An den Anschlüssen der Eingänge 12, 18 und 24 liegen über Widerstände 58, 60; 62, 64; 66, 68 bidirektionale "return-to-zero" - Signale mit den Spannungspegeln von + 12,5 Volt und - 12,5 Volt an, wie sie in der eingangs schon genannten ARINC 429-Luftfahrtnorm spezifiziert sind. An den Anschlüssen der Ausgänge 30 und 36 erscheinen jeweils zwei gegeneinander invertierte, TTL-kompatible non-return-to-zero" - Ausgangssignale. Diese Ausgangssignale werden in einer rein digitalen Empfangslogik weiterverarbeitet.

Die Anschlüsse 14 und 16 des ersten Eingangs 12 sind mit den beiden Eingängen eines ersten Komparators 70 verbunden. Die Anschlüsse 20 und 22 des zweiten Eingangs 18 sind mit den beiden Eingängen eines zweiten Komparators 72 verbunden. Die Anschlüsse 26 und 28 des dritten Eingangs 24 sind mit den beiden Eingängen eines dritten Komparators 74 verbunden. Die Komparatoren liefern an ihren Ausgängen entsprechende differentielle Ausgangssignale mit definiertem Spannungspegel.

Die Ausgänge des ersten Komparators 70 liegen an ersten Eingängen 76 und 78 eines ersten Multiplexers 80 an. Die Ausgänge des zweiten Komparators 72 liegen an zweiten Eingängen 82 und 84 des ersten Multiplexers 80 an. Die Ausgänge 86 und 88 des ersten Multiplexers 80 liegen an einer ersten Demodulatorschaltung 90 an.

Die Ausgänge des dritten Komparators 74 liegen an ersten Eingängen 92 und 94 eines zweiten Multiplexers 96 an. Die Ausgänge des zweiten Komparators 72 liegen auch an zweiten Eingängen 98, 100 des zweiten Multiplexers 96 an. Die Ausgänge 102 und 104 des zweiten Multiplexers 96 liegen an einer zweiten Demodulatorschaltung 106 an.

Der erste Multiplexer 80 ist von einem Auswahlsignal steuerbar, das an den Anschlüssen 42 des Demodulatorbausteins 10 angelegt wird. Der Anschluß 42 ist über eine Verbindung 108 mit einem Auswahleingang 110 des ersten Multiplexers 80 verbunden. Der zweite Multiplexer 96 ist von einem Auswahlsignal steuerbar, das an den Anschluß 44 des Demodulatorbausteins 10 angelegt wird. Der Anschluß 44 ist über eine Verbindung 112 mit einem Auswahleingang 114 des zweiten Multiplexers 96 verbunden.

Ein erster Ausgang 116 der Demodulatorschaltung 90 ist mit einem TTL-Treiber 118 verbunden. Ein zweiter Ausgang 120 der Demodulatorschaltung 90 ist mit einem TTL-Treiber 122 verbunden. Ein erster Ausgang 124 der zweiten Demodulatorschaltung 106 ist mit einem TTL-Treiber 126 verbunden. Ein zweiter Ausgang 128 der Demodulatorschaltung 106 ist mit einem TTL-Treiber 130 verbunden.

Der Ausgang des TTL-Treibers 118 ist mit dem Anschluß 32 verbunden. Der Ausgang des TTL-Treibers 122 ist mit dem Anschluß 34 verbunden. Der Ausgang des TTL-Treibers 126 ist mit dem Anschluß 38 verbunden. Der Ausgang des TTL-Treibers 130 ist mit dem Anschluß 40 verbunden. An den Anschlüssen 32 und 34 des Ausgangs 30 liegen zwei gegeneinander invertierte, TTL-kompatible "non-return-to-zero" - Ausgangssignale an. An den Anschlüssen 38 und 40 des Ausgangs 36 liegen zwei gegeneinander invertierte, TTL-kompatible "non-return-to- zero" - Ausgangssignale an.

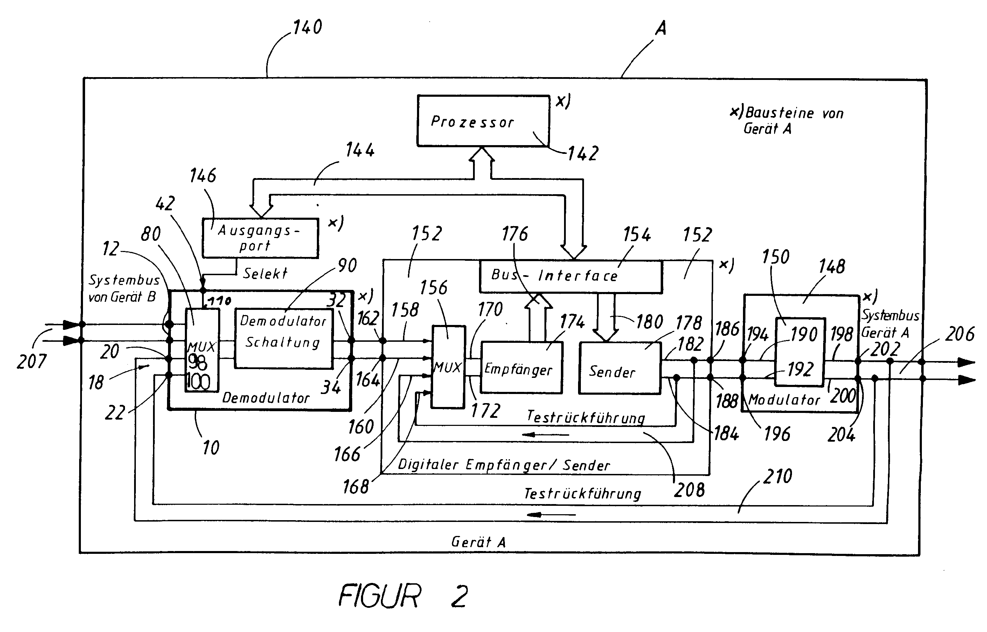

In Fig.2 ist eine Signalverarbeitungsanordnung dargestellt, in welcher der Demodulatorbaustein der im Zusammenhang mit Fig.1 beschriebenen Art so angeordnet ist, daß eine Prüfung nicht nur des Demodulators sondern auch eines Modulators im Betrieb mit operationellen Signalen erfolgen kann.

Ein Gerät A ist durch einen Block 140 angedeutet. Das Gerät A enthält eine Mehrzahl von integrierten Bausteinen: Mit 142 ist ein Prozessor bezeichnet. Der Prozessor 142 ist über einen Datenbus 144 mit einem Ausgangsport 146 verbunden. Der Ausgangsport ist verbunden mit dem Auswahleingang 42 des Demodulatorbausteins 10, der auch einen Teil des Gerätes A bildet. In Fig.2 ist zur Vereinfachung nur ein Multiplexer 80 und eine Demodulatorschaltung 90 angedeutet. Das Gerät A enthält weiterhin einen an sich bekannten Modulatorbaustein 148 mit einem Modulator 150. Ein weiterer Baustein des Gerätes A ist ein digitaler Sender/Empfänger-Baustein 152. Der Sender/ Empfänger - Baustein 152 steht über eine Datenleitungs-Schnittstelle 154 mit dem Datenbus 144 und damit mit dem Prozessor 142 in Verbindung.

Der Sender/Empfänger - Baustein 152 enthält einen Multiplexer 156. Der Multiplexer 156 weist ein erstes Paar von Eingängen 158 und 160 auf. Der Eingang 158 des Multiplexers 156 ist mit einem Anschluß 162 des Sender/ Empfänger - Bausteins 152 verbunden. Der Eingang 160 des Multiplexers 156 ist mit einem Anschluss 164 des Sender/ Empfänger - Bausteins 152 verbunden. Der Multiplexer 156 weist ferner ein zweites Paar von Eingängen 166 und 168 auf. Zwei Ausgänge 170 und 172 des Multiplexers sind mit einem Empfänger 174 verbunden. Der Empfänger 174 steht über einen Datenbus 176 mit der Datenbus-Schnittstelle 154 in Verbindung. Ferner enthält der Sender/Empfänger - Baustein 152 einen Sender 178. Der Sender 178 ist über einen Datenbus 180 mit der Datenleitungs-Schnittstelle 154 verbunden. Der Sender 178 hat zwei Ausgänge 182 und 184. Der Ausgang 182 ist mit einem Anschluß 186 des Sender/Empfänger - Bausteins 152 verbunden. Der Ausgang 184 ist mit einem Anschluß 188 des Sender/Empfänger - Bausteins 152 verbunden.

Die Ausgänge 32 und 34 des Demodulatorbausteins 10 sind mit den Eingängen 162 bzw. 164 des Sender/Empfänger - Bausteins 152 verbunden. An dem Eingang 12 des Demodulatorbausteins 10 liegen Signale vom Systembus 207 eines anderen Gerätes B.

Der Modulator 150 weist zwei Eingänge 190 und 192 auf. Die Eingänge 190 und 192 sind mit Anschlüssen 194 bzw. 196 des Modulatorbausteins 148 verbunden. Der Modulator 150 weist ferner zwei Ausgänge 198 und 200 auf. Die Ausgänge 198 und 200 sind mit Anschlüßen 202 und 204 des Modulatorbausteins 148 verbunden. Die Anschlüsse 202 und 204 sind mit Leitungen des Systembus 206 des Gerätes A verbunden.

Der Sender/Empfänger - Baustein 152 weist eine interne Prüfrückführschleife 208 auf. Die Prüfrückführschleife 208 verbindet die Ausgänge 182 und 184 des Senders innerhalb des Sender/Empfänger - Bausteins 152 mit den Eingängen 166 bzw. 168 des Multiplexers 156. Auf diese Weise kann der Sender/Empfänger - Baustein im Betrieb mit operationellen Signalen geprüft werden. Es werden für diese Prüfung statt der Eingänge 158 und 160 die Eingänge 166 und 168 auf den Empfänger 174 geschaltet. Der Prozessor 142 kann dann feststellen, ob die vom Empfänger 174 empfangenen und an den Prozessor 142 weitergeleiteten Signale mit den vom Sender 178 ausgesandten Signalen übereinstimmen. Wenn das nicht der Fall ist, ist dies ein Anzeichen für einen Defekt der Sender/Empfänger - Einheit 152.

Eine weitere Prüfrückführschleife 210 ist von den Klemmen 202 und 204 des Modulatorbausteins 148 zu dem Eingang 18 mit den Anschlüssen 20 und 22 des Demodulatorbausteins 10 geführt. Auf diese Weise sind die Ausgangssignale des Modulators 150 auf die Eingänge 98 und 100 des Multiplexers 80 geschaltet. Durch ein Signal, das von dem Prozessor 142 über den Ausgangsport 146 und KLemme 42 auf den Auswahleingang 110 des Multiplexers 80 gegeben wird, wird zu Prüfzwecken dieses Signal vom Ausgang des Modulators 150 auf die Demodulatorschaltung 90 aufgeschaltet. Das vom Empfänger 174 über die Eingänge 158, 160 des Multiplexers 156 und die Eingänge 170 und 172 erhaltenen Signale müssen dann mit den von dem Sender 178 abgegebenen Signalen übereinstimmen. Wenn durch eine vorherige Prüfung, wie oben beschrieben, festgestellt ist, daß der Sender/Empfänger - Baustein 152 intakt ist, dann bedeutet eine Nichtübereinstimmung, daß entweder der Modulatorbaustein 148 oder der Demodulatorbaustein 10 defekt ist.

Bei der Ausführung des Demodulatorbausteins nach Fig.1 kann auch noch festgestellt werden, ob der Modulatorbaustein 148 oder der Demodulatorbaustein 10 defekt ist. Zu diesem Zweck wird zunächst die Prüfrückführschleife 210 über den Eingang 18 und den Multiplexer 80 mit einem Auswahlsignal an dem Anschluß 42 und dem Auswahleingang 110 auf die Demodulatorschaltung 90 geschaltet. Wird dann von dem Prozessor 142 Nichtübereinstimmung der Signale festgestellt, also ein Defekt entweder des Modulatorbausteins 148 oder des Demodulatorbausteins 10, dann wird ein Auswahlsignal auf den An schluß 44 und den Auswahleingang 114 des zweiten Multiplexers 96 gegeben.

Der zweite Multiplexer 96 schaltet dann die Prüfrückführschleife 210 auf die zweite Demodulatorschaltung 106. Wird dann durch den Prozessor 142 Übereinstimmung zwischen ausgesandtem und empfangenen Signal festgestellt, dann ist die Demodulatorschaltung 90 defekt. Wird aber auch nach der Umschaltung durch den Prozessor keine übereinstimmung zwischen ausgesandtem und empfangenen Signal festgestellt, dann liegt der Defekt im Modulatorbaustein 148.

## Patentansprüche

1. Demodulatorbaustein mit einer Demodulatorschaltung (90), einem ersten Eingang (12) und einem mit der Demodulatorschaltung (90) verbundenen Ausgang (30), **dadurch gekennzeichnet,** dass
a) der Demodulatorbaustein (10) eine erste und eine zweite Demodulatorschaltung (90, 106) enthält,
b) der Demodulatorbaustein (10) weiterhin einen ersten, der ersten Demodulatorschaltung (90) zugeordneten Multiplexer (80) und einen zweiten, der zweiten Demodulatorschaltung (106) zugeordneten Multiplexer (96) enthält,
c) der erste Eingang (12) des Demodulatorbausteins (10) über den ersten Multiplexer (80) auf die erste Demodulatorschaltung (90) aufschaltbar ist,
d) ein zweiter Eingang (18) über den ersten Multiplexer (80) auf die erste Demodulatorschaltung (90) aufschaltbar ist,
e) der Demodulatorbaustein (10) einen dritten Eingang (24) aufweist,
f) der zweite Eingang (18) über den zweiten Multiplexer (96) wahlweise auf die zweite Demodulatorschaltung (106) aufschaltbar ist,
g) der dritte Eingang (24) über den zweiten Multiplexer (96) wahlweise auf die zweite Demodulatorschaltung aufschaltbar ist,
h) der Demodulatorbaustein (10) einen ersten Ausgang (30) aufweist, der mit der ersten Demodulatorschaltung (90) verbunden ist, und einen zweiten Ausgang (36) aufweist, der mit der zweiten Demodulatorschaltung (106) verbunden ist, und
i) der erste Multiplexer (80) von einem ersten Auswahleingang (42) des Demodulatorbausteins (10) gesteuert ist und der zweite Multiplexer (96) von einem zweiten Auswahleingang (44) des Demodulatorbausteins (10) gesteuert ist.

2. Demodulatorbaustein nach Anspruch 1, **dadurch gekennzeichnet,** dass zu Prüfzwecken Signale im operativen Betrieb auf den zweiten Eingang (18) aufschaltbar und durch den Demodulatorbaustein (10) verarbeitbar sind.

3. Signalverarbeitungsanordnung mit einem Prozessor (142), der über einen Datenbus (144) und einen Sender/Empfänger-Bauteil (152) Signale auf einen Modulatorbaustein (148) zur Weitergabe an den Systembus (206) eines ersten Gerätes (A) liefert und vom Systembus (207) eines zweiten Gerätes (B) Signale über einen Demodulatorbaustein (10) nach einem der Ansprüche 1 bis 2, den Sender/Empfänger-Baustein und den Datenbus (144) erhält, **dadurch gekennzeichnet,** dass der Ausgang (202, 204) des Modulatorbausteins (148) über eine Prüfrückführschleife (210) mit dem zweiten Eingang (18) des Demodulatorbauteils (10) verbunden ist.

## Claims

1. Demodulator component including a demodulator circuit (90), a first input (12) and an output (30) connected to the demodulator circuit (90),
**characterized in that**
a) the demodulator component (10) contains a first and a second demodulator circuit (90,106),
b) the demodulator circuit (10) further contains a first multiplexer (80), which is associated with the first demodulator circuit (90), and a second multiplexer (96), which is associated with the second demodulator circuit (106),
c) the first input (12) of the demodulator component (10) is connectable to the first demodulator circuit (90) through the first multiplexer (80),
d) a second input (18) is connectable to the first demodulator circuit (90) through the first multiplexer (80),
e) the demodulator component (10) comprises a third input (24),
f) the second input (18) is selectively connectable to the second demodulator circuit (106) through the second multiplexer (96),
g) the third input (24) is selectively connectable to the second demodulator circuit through the second multiplexer (96),
h) the demodulator component (10) comprises a first output (30) connected to the first demodulator circuit (90), and comprises a second output (36) connected to the second demodulator circuit (106), and
i) the first multiplexer (80) is controlled by a first selector input (42) of the demodulator component (10) and the second multiplexer (96) is controlled by a second selector input (44) of the demodulator component (10).

2. Demodulator component according to claim 1, **characterized in that**, during operative performance, signals for testing purposes are applicable to the second input (18) and processable by the demodulator component (10).

3. Signal processing arrangement including a processor (142) which supplies signals via a data bus (144) and a transmitter/receiver component (152) to a modulator component (148) for further transmission to the system bus (206) of a first device (A) and which receives, from the system bus (207) of a second device (B), signals via a demodulator component (10) according to any one of claims 1 to 2, the transmitter/receiver component and the data bus (144), **characterized in that** the output (202,204) of the modulator component (148) is connected to the second input (18) of the demodulator component (10) via a test feedback loop (210).

## Revendications

1. Elément démodulateur muni d'un circuit de démodulateur (90), d'une première entrée (12) et d'une sortie (30) reliée au circuit de démodulateur (90), **caractérisé par le fait** que
a) l'élément démodulateur (10) contient un premier et un deuxième circuit de démodulateur (90, 106),
b) l'élément démodulateur (10) comprend en outre un premier multiplexeur (80) associé au premier circuit de démodulateur (90) et un second multiplexeur (96) associé au second circuit de démodulateur (106),
c) la première entrée (12) de l'élément démodulateur (10) est susceptible d'être appliquée par l'intermédiaire du premier multiplexeur (80) au premier circuit de démodulateur (90),
d) une deuxième entrée (18) est susceptible d'être appliquée par l'intermédiaire du premier multiplexeur (80) au premier circuit de démodualteur (90),
e) l'élément démodulateur (10) présente une troisième entrée (24),
f) la deuxième entrée (18) est susceptible d'être appliquée par l'intermédiaire du second mutiplexeur (96) au choix au second circuit de démodulateur (106),
g) la troisième entrée (24) est susceptible d'être appliquée par l'intermédiaiare du second multiplexeur (96) au second circuit de démodulateur,
h) l'élément démodulateur (10) présente une première sortie (30) reliée au premier circuit de démodulateur (90) et présente une seconde sortie (36) reliée au second circuit de démodulateur (106) et,
i) le premier multiplexeur (80) est commandé par une première entrée de sélection (42) de l'élément démodulateur (10) et le second multiplexeur (96) est commandé par une seconde entrée de sélection (44) de l'élément démodulateur (10).

2. Élément démodulateur selon la revendication 1, **caractérisé par le fait** qu'à des fins de contrôle des signaux sont susceptibles d'être appliqués en fonctionnement opératif à la deuxième entrée (18) et d'être traités par l'élément démodulateur (10).

3. Dispositifs de traitement de signaux muni d'un processeur (142) qui livre des signaux, par l'intermédiaire d'un bus de données (144) et d'un élément émetteur-récepteur (152), à un élément modulateur (148) destiné à retransmettre au bus de système (206) d'un premier appareil (A) et qui reçoit des signaux du bus de système (207) d'un second appareil (B), par l'intermédiaire d'un élément démodulateur (10), selon l'une des revendications 1 à 2, de l'élément émetteur-récepteur et du bus de données (144), **caractérisé par le fait** que la sortie (202, 204) de l'élément modulateur (148) est reliée par l'intermédiaire d'un feed-back de vérification (210) à la seconde entrée (18) de l'élément démodulateur (10).
